# EUROPÄISCHE PATENTSCHRIFT

(11) **EP 3 011 589 B1**
(45) Veröffentlichungstag und Bekanntmachung des Hinweises auf die Patenterteilung: **26.07.2017**
(21) Anmeldenummer: 13731716.0
(22) Anmeldetag: 17.06.2013
(51) Int. Cl.: H01L 21/66, H01L 21/67, H01L 21/68, B65G 47/26

(54) **VORRICHTUNG UND VERFAHREN ZUM AUSRICHTEN VON SUBSTRATEN**
DEVICE AND METHOD FOR ALIGNING SUBSTRATES
DISPOSITIF ET PROCÉDÉ PERMETTANT D'ALIGNER DES SUBSTRATS

(43) Veröffentlichungstag der Anmeldung: 27.04.2016
(73) Patentinhaber: Ev Group E. Thallner GmbH, 4782 St. Florian am Inn (AT)
(72) Erfinder: THALLNER, Erich, A-4782 St. Florian (AT)
(74) Vertreter: Schneider, Sascha
(86) Internationale Anmeldenummer: PCT/EP2013/062473
(87) Internationale Veröffentlichungsnummer: WO 2014/202106

(56) Entgegenhaltungen:
- EP-A1- 2 299 472
- WO-A1-2010/038454
- US-A1- 2007 252 994

## Beschreibung

Die vorliegende Erfindung betrifft ein Verfahren zum Ausrichten und Kontaktieren eines ersten Substrats mit einem zweiten Substrat nach Anspruch 1 sowie eine korrespondierende Vorrichtung nach Anspruch 4.

In der Halbleiterindustrie werden seit mehreren Jahren Substrate miteinander verbunden. Es ist meistens notwendig, die Substrate vor dem eigentlichen Verbindungsvorgang, dem Bonden, zueinander auszurichten. Die Ausrichtung der Substrate zueinander erfolgt mit Ausrichtungsanlagen. Die Ausrichtungsanlagen sind in der Lage, Ausrichtungsmarken auf den Substraten zu detektieren und die Substrate so zueinander auszurichten, dass die Ausrichtungsmarken sich entsprechend ergänzen. In den meisten Fällen sind die Ausrichtungsmarken komplementär zueinander.

Um zwei Substrate korrekt zueinander auszurichten, benötigt man mindestens vier Ausrichtungsmarken, zwei auf jedem Substrat. Die Ausrichtungsmarken liegen mit Vorzug möglichst nahe am Rand des Substrats um die Ausrichtungsgenauigkeit zu erhöhen.

Bei einem Ausrichtungsprozess unterschiedet man immer zwischen der Grenzschichtoberfläche und der, der Grenzschichtoberfläche gegenüber liegenden, Oberfläche eines Substrats. Die Grenzschichtoberfläche ist die Oberfläche des Substrats, die später Teil der Bondgrenzfläche wird. Eine Ausrichtungsmarke, die sich auf einer Grenzschichtoberfläche befindet wird als "face-side" Ausrichtungsmarke bezeichnet, eine Ausrichtungsmarke auf der entsprechend gegenüberliegenden Seite nennt man "back-side" Ausrichtungsmarke. Dementsprechend gibt es vier grundsätzliche Ausrichtungsvarianten, "back-to-back", "face-to-face", "face-to-back" und "back-to-face" Ausrichtungen.

Bei der "back-to-back" Ausrichtung treten keine gravierenden Probleme auf, da sich die Ausrichtungsmarken eigentlich immer auf, für alle Optiken, frei zugänglichen, da nach außen gerichteten Oberflächen befinden.

Eine besondere Herausforderung in der Ausrichtungstechnologie stellt die "face-to-face" Variante dar. In dieser Ausrichtungsvariante sind die Ausrichtungsmarken immer zur Bondgrenzfläche, also zur Ebene zwischen den beiden Substraten, ausgerichtet. Eine Möglichkeit besteht in der Transmissionsdetektierung, Transmissionsvermessung und Transmissionsausrichtung, die nur dann verwendet werden, wenn alle Schichten auf dem Substrat, inklusive dem Substrat selbst, transparent für die elektromagnetische Wellen des jeweils verwendeten elektromagnetischen Spektrums sind. Das ist vor allem für IR-Strahlung und sichtbares Licht nicht immer der Fall.

Einen anderen, dritten Ansatz verfolgt die Ausrichtungsanlage in der Patentschrift AT405775B. In dieser Patentschrift wird gezeigt, dass es möglich ist, die "front" Oberflächen der beiden zueinander auszurichtenden Substrate fast bis auf Kontakt aneinander anzunähern. Das obere und das untere Substrat werden durch entsprechende Probenhalter auf einem oberen bzw. unteren Schlitten fixiert und können translatorisch, jeweils wechselseitig aus der Ausrichtungsstation in eine Messstation gefahren werden, in welcher die jeweiligen x- und y-Positionen der jeweils linken bzw. rechten Ausrichtungsmarken des jeweils oberen bzw. unteren Substrats korrekt vermessen werden können. Der Vorteil in der Patentschrift AT405775B liegt vor allem darin, dass die Substrate vor und während des Ausrichtungsprozesses einen extrem geringen Abstand in z-Richtung besitzen, und daher bei der Annäherung der beiden Substrate zueinander auch nur mehr einen sehr kurzen Weg in z-Richtung zurücklegen müssen um miteinander in Kontakt gebracht zu werden. Auf diesem extrem kurzen Weg fällt die Abweichung von der gewünschten Ausrichtungsgenauigkeit in x-bzw. y-Richtung kaum mehr ins Gewicht. Weitere Ausrichtungsanlagen sind in den Patentschriften US 2007/252994 A1 und WO 2010/038454 A1 offenbart.

Eines der größten technischen Probleme stellen die, durch die Bewegung der Substrate entstehenden, Positionierungsfehler dar, die insbesondere in einer evakuierbaren Umgebung auftreten können. Unter solchen Bedingungen können keine Luftlagerungen mehr verwendet werden, mit welchen eigentlich ein reibungsloses Gleiten der Schlitten gewährleistet werden sollte.

Aufgabe der vorliegenden Erfindung ist es daher, eine Vorrichtung und ein Verfahren zum Ausrichten und Kontaktieren von Substraten anzugeben, mit dem eine genauere und effizientere Ausrichtung und Kontaktierung von Substraten ermöglicht wird.

Diese Aufgabe wird mit den Merkmalen der Ansprüche 1 und 4 gelöst. Vorteilhafte Weiterbildungen der Erfindung sind in den Unteransprüchen angegeben.

Der Erfindung liegt der Gedanke zugrunde, insbesondere durch Vorsehen mehrerer Erfassungspositionen außerhalb der Ausrichtungsposition, die Erfassung der Relativpositionen zweier Substrate zueinander mit minimalsten Verfahrwegen der Substrate zu realisieren, vorzugsweise ohne eine Veränderung eines Abstands A zwischen den Substraten während der Erfassung, wobei nach der Erfassung eine Kontaktierung ausschließlich durch Bewegung der Substrate in z-Richtung, also aufeinander zu, erfolgt. Der Abstand A zwischen den Substraten ist dabei möglichst minimal, ohne bei einer Erfassung von Merkmalen auf den Substraten, mit Vorzug von Ausrichtungsmarken, in einer Erfassungsposition Erfassungsmittel zwischen die Substrate einzubringen. Somit können sowohl die Verfahrwege in X- und Y-Richtung während der Erfassung und Ausrichtung minimiert werden als auch die Verfahrwege in Z-Richtung nach der Ausrichtung bis zur Kontaktierung.

Die erfindungsgemäßen Ausführungsformen zeigen vor allem eine neue und erfinderische Apparatur, mit der die Ausrichtung und Kontaktierung von Substraten erstmals mit hoher Präzision im Vakuum möglich ist.

Erfindungsgemäß ist es dabei insbesondere vorgesehen, dass die Erfassung durch Bewegung der Substrate in unterschiedliche Richtungen in der X-Y-Ebene in mindestens zwei unterschiedliche Erfassungspositionen erfolgt, vorzugsweise durch gegenläufige parallele Verschiebung der Substrate.

Gemäß einer vorteilhaften Ausführungsform der Erfindung ist vorgesehen, die erste und vierte Ausrichtungsmarkierung und/oder die zweite und dritte Ausrichtungsmarkierung in Z-Richtung gegenüberliegend anzuordnen. Insbesondere ist es erfindungsgemäß von Vorteil, wenn die Ausrichtungsmarkierungen jeweils an voneinander abgewandten Seiten, vorzugsweise an Rückseiten der Kontaktflächen der Substrate, angeordnet sind und/oder Erfassungsgeräte der Erfassungseinheiten als Erfassungsgerätpaare eine zur Kontaktfläche abgewandte Erfassungsseite erfassend ausgebildet sind. Dies kann insbesondere dadurch realisiert werden, dass die Erfassungsgeräte parallel zu und seitlich von korrespondierenden Justiereinrichtungen der Ausrichtungseinheit angeordnet sind, vorzugsweise paarweise seitlich gegenüberliegend.

Soweit die Erfassung der ersten und zweiten Ausrichtungsmarkierung und/oder die Erfassung der dritten und vierten Ausrichtungsmarkierung in einem zusammenhängenden Verfahrensschritt, insbesondere gleichzeitig, insbesondere mit einer ersten Erfassungseinheit zur Erfassung der ersten und/oder zweiten Ausrichtungsmarkierungen und einer zweiten Erfassungseinheit zur Erfassung der dritten und/oder vierten Ausrichtungsmarkierungen erfolgt, können äußerst kurze Verfahrwege mit nur zwei Erfassungspositionen realisiert werden.

Es ist weiterhin erfindungsgemäß von Vorteil, wenn gemäß einer vorteilhaften Ausführungsform eine erste und/oder zweite Justiereinheit als Kontaktierungsmittel vorgesehen ist. Vorzugsweise sind die Justiereinheiten zueinander fluchtend gegenüber angeordnet und diese dienen jeweils zur Justierung und Bewegung, insbesondere einschließlich Rotationsbewegung, der Aufnahmen zur Aufnahme der Substrate.

Gemäß einer weiteren vorteilhaften Ausführungsform der Erfindung ist vorgesehen, dass die Erfassungsmittel eine erste Erfassungseinheit zur Erfassung der ersten und/oder zweiten Ausrichtungsmarkierungen und eine zweite, insbesondere an einer zur ersten Erfassungseinheit gegenüberliegenden Seite der Aufnahmen angeordnete, Erfassungseinheit zur Erfassung der dritten und/oder vierten Ausrichtungsmarkierungen aufweisen.

Dabei ist es von besonderem Vorteil, wenn die erste Erfassungseinheit mehrere elektromagnetische Einheiten, insbesondere zwei gegenüberliegend angeordnete, erste Erfassungsgeräte, vorzugsweise Mikroskope, und/oder die zweite Erfassungseinheit mehrere elektromagnetische Einheiten der, insbesondere zwei gegenüberliegend angeordnete, zweite Erfassungsgeräte, vorzugsweise Mikroskope, aufweisen.

Soweit die erste Erfassungseinheit eine erste Optikfixierung zur Anbringung der ersten Erfassungsgeräte und/oder die zweite Erfassungseinheit eine zweite Optikfixierung zur Anbringung der zweiten Erfassungsgeräte aufweist, sind die Erfassungseinheiten bzw. die Erfassungsgeräte, insbesondere nach einer vorherigen Kalibrierung, relativ zueinander fixierbar, so dass eine erfindungsgemäße Kalibrierung nur einmal für eine Vielzahl von Messungen erfolgen muss. Weiterhin kann es von Vorteil sein, wenn die ersten Erfassungsgeräte durch eine die erste Optikfixierung aufnehmende erste Fixierungstranslationseinheit und/oder die zweiten Erfassungsgeräte durch eine die zweite Optikfixierung aufnehmende zweite Fixierungstranslationseinheit gemeinsam bewegbar sind. Auf diese Weise können die kalibrierten Optikfixierungen und Erfassungsgeräte auch nach einer Kalibrierung noch gemeinsam bewegt werden.

Die Erfindung kann weiter verbessert werden, wenn gemäß einer Ausführungsform die ersten Erfassungsgeräte jeweils separat über erste Optiktranslationseinheiten an der ersten Optikfixierung bewegbar sind und/oder die zweiten Erfassungsgeräte jeweils separat über zweite Optiktranslationseinheiten an der Optikfixierung bewegbar sind.

Die Erfindung betrifft insbesondere eine Vorrichtung (Ausrichtungsanlage), welche, mit Vorzug möglichst weit am seitlichen Umfangsrand in einem Umfangsbereich liegenden, Ausrichtungsmarkierungen zweier Substrate durch verhältnismäßig kurze Verfahrwege in X- und/oder Y-Richtung (also entlang der Kontaktflächen) vermessen kann. Des Weiteren handelt die Erfindung von einer Methode, die, mit Vorzug möglichst weit am Rand liegenden, Ausrichtungsmarkierungen zweier Substrate durch verhältnismäßig kurze Verfahrwege in X- und/oder Y- Richtung vermessen kann. Verhältnismäßig kurz heißt erfindungsgemäß insbesondere weniger als um die Hälfte des Durchmessers der Substrate pro Vermessungs- bzw. Erfassungsschritt. Als Verfahrweg wird dabei der Weg von der jeweiligen Ausrichtungsposition zu einer Erfassungsposition in X-, Y- und/oder Z-Richtung definiert.

Unter Substraten werden in der Halbleiterindustrie verwendete Produkt- oder Trägersubstrate verstanden. Ein Trägersubstrat dient als Verstärkung des Funktionssubstrates (Produktsubstrat) bei den verschiedenen Bearbeitungsschritten, insbesondere beim Rückdünnen des Funktionssubstrates. Als Substrate kommen insbesondere Wafer, entweder mit Abflachung ("flat") oder Einkerbung ("notch"), in Frage.

Funktionale Bauteile der erfindungsgemäßen Vorrichtung wie Schlitten, Motoren, Optiken, Halterungen sind mit Vorzug in einem Gehäuse verbaut. Das Gehäuse ist insbesondere hermetisch zur Umgebung abschließbar. Das Gehäuse besitzt mit Vorzug einen Deckel, welcher den Zugang zu den funktionalen Bauteilen ermöglicht. Insbesondere ist an mindestens einer Seite des Gehäuses ein Schleusentor vorgesehen. Dem Schleusentor kann eine entsprechende Schleuse vor- und/oder nachgeschaltet sein. Bei Verwendung einer Schleuse vor und/oder nach dem Schleusentor kann man mit Vorzug im Gehäuse eine andere Atmosphäre einstellen als in der Umgebung des Gehäuses. Die Atmosphäre ist vorzugsweise eine Unterdruckatmosphäre.

Während eines erfindungsgemäßen Ausrichtungsvorganges beträgt der Druck im Inneren des Gehäuses gleich 1bar, mit Vorzug weniger als 10⁻¹ mbar, mit größerem Vorzug weniger als 10⁻³ mbar, mit größtem Vorzug weniger als 10⁻⁵ mbar, mit allergrößtem Vorzug weniger als 10⁻⁸ mbar.

Während eines erfindungsgemäßen Ausrichtungsvorganges beträgt der Druck außerhalb des Gehäuses gleich 1bar, mit Vorzug weniger als 10⁻¹ mbar, mit größerem Vorzug weniger als 10⁻³ mbar, mit größtem Vorzug weniger als 10⁻⁵ mbar, mit allergrößtem Vorzug weniger als 10⁻⁸ mbar.

Alle Substrate können entweder über ein Schleusentor oder den Deckel in den Innenraum eingebracht werden. Mit Vorzug werden die Substrate über das Schleusentor in den Innenraum transportiert.

In einer besonderen Ausführungsform erfolgt der Transport der Substrate bzw. des aus den zueinander ausgerichteten Substraten bestehenden Substratstapels aus dem Gehäuse mittels eines Roboters.

Eine Ausrichtungseinheit umfasst insbesondere zwei Justiereinheiten, auf welchen jeweils Aufnahmen in Y, -Y-, Z- und/oder jeweils in zugehörigen Rotationsrichtungen bewegbar, insbesondere justierbar angeordnet sind. An den Aufnahmen sind die Substrate aufnehmbar und die Ausrichtungseinheit dient der Ausrichtung und Kontaktierung der Substrate.

Erfindungsgemäß werden insbesondere jeweils zwei Erfassungsgeräte (vorzugsweise Optiken), die sich auf entsprechenden Translationseinheiten und/oder Goniometern befinden, über eine, insbesondere U-förmige, Optikfixierung mechanisch miteinander gekoppelt, insbesondere relativ zueinander fixierbar. Diese werden nachfolgend als Erfassungsmittel bezeichnet.

Erfindungsgemäß ist es denkbar, jedes einzelne Erfassungsgerät und damit vor allem die optische Achse, durch ein, sich zwischen der Optik und der Translationseinheit befindendes, im Allgemeinen dreiachsiges, Goniometer im Raum zu orientieren. Die Translationseinheiten oder Goniometer zwischen den Erfassungsgerät und der Optikfixierung dient der individuellen und unabhängigen Verschiebung eines jeden Erfassungsgeräts relativ zu den anderen Erfassungsgeräten.

Die Genauigkeit, mit der die Erfassungsgeräte einzeln bewegt werden können, ist besser als 1mm, mit Vorzug besser als 100µm, mit großem Vorzug besser als 10µm, mit größerem Vorzug besser als 1µm, mit noch größerem Vorzug besser als 100nm, mit allergrößtem Vorzug besser als 10nm.

Die Optikfixierungen befinden sich insbesondere jeweils auf einer weiteren Fixierungstranslationseinheit, die für die Translation der gesamten, die jeweils zugeordneten Erfassungsgeräte aufweisenden Optikfixierung verantwortlich ist.

Erfindungsgemäß ist mindestens ein Erfassungsmittel auf einer Seite der Aufnahmen und mindestens ein weiteres Erfassungsmittel auf einer weiteren, insbesondere gegenüberliegenden, Seite angeordnet.

Die Genauigkeit mit der die Optikfixierungen einzeln bewegt werden können ist besser als 1mm, mit Vorzug besser als 100µm, mit großem Vorzug besser als 10µm, mit größerem Vorzug besser als 1µm, mit noch größerem Vorzug besser als 100nm, mit allergrößtem Vorzug besser als 10nm.

Der Verfahrweg einer jeden Optikfixierung für jede der drei Translationsrichtungen ist größer als 10µm, mit Vorzug größer als 1mm, mit größerem Vorzug größer als 10mm, mit größtem Vorzug größer als 100mm, insbesondere aber kleiner als zwei Drittel, vorzugsweise kleiner als die Hälfte, des Durchmessers der Kontaktfläche des ersten und/oder zweiten Substrats.

Die Optikfixierung, die Menge aller Bauteile, die durch die Optikfixierung gekoppelt sind, sowie die Translationseinheit für die Optikfixierung werden erfindungsgemäß als Erfassungseinheit bzw. Erfassungsmittel bezeichnet.

In der Ausrichtungseinheit befindet sich, insbesondere an der Ober- und Unterseite, jeweils eine Justiereinheit für jedes der beiden Substrate. Auf jeder Justiereinheit befindet sich ein Probenhalter als Aufnahme. Jeder Probenhalter besitzt insbesondere sechs Freiheitsgrade, drei Freiheitsgrade der Translation entlang der X-, Y- und Z-Richtung, sowie drei Freiheitsgrade der Rotation um die X-, Y- und Z-Achse, im Folgenden mit den Winkeln Alpha, Beta und Gamma bezeichnet. Die Translationsfreiheitsgrade dienen der Verschiebung des Probenhalters und damit des Substrats innerhalb der durch die X- und die Y-Richtung aufgespannten X-Y Ebene sowie der Annäherung der beiden Substrate zueinander entlang der Z-Richtung. Die Rotationsmöglichkeit um die X-, Y- und Z-Achse dient erfindungsgemäß zur Durchführungen eines Keilfehlerausgleichs und/oder der Orientierung des Substrats. Bei den Rotationen um die X-, Y- und Z-Achse handelt es sich insbesondere um Rotationen mit geringen Rotationswinkeln, sodass man auch von einer Kippung sprechen könnte.

Erfindungsgemäß können Probenhalter als Aufnahmen für die Substrate insbesondere mit den folgenden unterschiedlichen Fixiermechanismen verwendet werden:
- Vakuumprobenhalter
- Elektrostatischer Probenhalter
- Probenhalter mit einer adhäsiven Oberfläche
- Probenhalter, die auf Venturi und Bernoullieffekten beruhen
- Magnetische Probenhalter
- Probenhalter mit mechanischen Fixierungen

Bei der Verwendung der erfindungsgemäßen Ausführungsform in einer Vakuumumgebung werden allerdings Vakuumprobenhalter und/oder Venturi- und/oder Bernoulliprobenhalter nur eingeschränkt, im Extremfall gar nicht verwendet. Erfindungsgemäß denkbar wäre die Verwendung eines Vakuumprobenhalters dann, wenn die Evakuierung im Innenraum der erfindungsgemäßen Ausführungsform durch eine erste Vakuumpumpe zu einer Atmosphäre, die man durch ein, vom Regelkreis der ersten Vakuumpumpe, zweit Vakuumpumpe erzeugt.

Vor dem eigentlichen Ausrichtungsvorgang ist erfindungsgemäß eine Kalibrierung der Erfassungsmittel von Vorteil. Das Ziel der Kalibrierung besteht insbesondere darin, den Schnittpunkt der optischen Achsen zweier, jeweils gegenüberliegender Erfassungsgeräte in das Zentrum einer Ausrichtungsmarkierung eines Kalibrierungssubstrats zu legen. Diese Kalibrierung erfolgt vorzugsweise getrennt für alle Erfassungsgeräte der Erfassungseinheiten. Durch die Kalibrierung wird sichergestellt, dass gegenüberliegende (obere und untere) Erfassungsgeräte einer Erfassungseinheit einen gemeinsamen Fokusbereich aufweisen.

In einer bevorzugten Ausführungsform sind die optischen Achsen der beiden gegenüberliegenden Erfassungsgeräte kollinear zueinander. Hierzu weisen die Optiken insbesondere Rotationsfreiheitsgrade auf, vorzugweise durch Anordnung auf einem Goniometer.

Ein oder der Schnittpunkt der optischen Achsen der Erfassungsgeräte wird erfindungsgemäß insbesondere so angeordnet, dass die korrespondierenden Ausrichtungsmarkierungen der auszurichtenden Substrate in der Erfassungsposition in X-, Y- und Z-Richtung in diesem Punkt zumindest fokussierbar und/oder anordenbar bzw. angeordnet sind. Im Allgemeinen können sich die Positionen der Ausrichtungsmarkierungen von Substratpaar zu Substratpaar ändern. Durch diese Maßnahme werden die Verfahrwege erfindungsgemäß weiter minimiert.

Die Schnittpunkte der optischen Achsen befinden sich mit Vorzug in der Fokusebene der Optiken. Auflösung und Tiefenschärfebereich sind zwei miteinander konkurrierende Parameter. Je größer die Auflösung, desto kleiner der Tiefenschärfebereich und umgekehrt. Verwendet man also Optiken mit einem hohen Auflösungsvermögen, besitzen diese einen entsprechend geringen Tiefenschärfebereich. Dadurch müssen die Ausrichtungsmarken des oberen und unteren Substrats sich gleichzeitig innerhalb eines sehr kleinen Tiefenschärfebereichs aufhalten, um noch scharf abgebildet werden zu können. Erfindungsgemäß wird der Schnittpunkt der optischen Achsen im Tiefenschärfebereich der korrespondierenden Erfassungsgeräte angeordnet.

Erfindungsgemäß ist es von Vorteil, wenn die Erfassungsgeräte so kalibriert werden, dass die Kontaktflächen und/oder die Ausrichtungsmarkierungen der Substrate in den Erfassungspositionen der jeweiligen Erfassungseinheiten innerhalb der Tiefenschärfebereiche angeordnet sind. Dadurch kann erfindungsgemäß auf eine Nachfokussierung verzichtet werden.

Die optischen Achsen zweier gegenüberliegender Optiken werden zwar mit Vorzug auf eine Ausrichtungsmarkierung ausgerichtet, sodass zumindest der Schnittpunkt der optischen Achsen in der Ausrichtungsmarkierung, und damit im Fokusbereich, zu liegen kommt. Für den Fall, dass sich die optischen Achsen aus einem beliebigen Grund nicht in einem Punkt innerhalb des Fokusbereichs schneiden, sollte zumindest der Abstand zwischen den optischen Achsen bekannt sein. Richtet man nämlich im späteren Ausrichtungsprozess eine der optischen Achsen auf eine Ausrichtungsmarke eines Substrats aus, kann man das dem ersten Substrat gegenüberliegende Substrat noch korrekt orientieren, indem das dem Substrat gegenüberliegende Substrat versetzt wird, um den Abstand zwischen den beiden optischen Achsen zu positionieren.

Im Folgenden werden einige Beispiele angegeben, warum die optischen Achsen zweier gegenüberliegender Optiken im Laufe der Zeit driften und sich daher deren Schnittpunktpunkte mit der Fokusebene verschieben.

Während des laufenden Betriebes werden sich die optischen Achsen, vorwiegend auf Grund von Erschütterungen und/oder thermischen Dehnungen des Gesamtsystems, verschieben. Man müsste also nach einiger Zeit, selbst wenn keine grobe Veränderung, wie beispielsweise eine Wartung, eine Erweiterung oder ein Austausch der Optiken, ein Softwareupdate, ein Hardwareupdate etc., an der erfindungsgemäßen Ausführungsform durchgeführt wurde, erneute eine vollständige Kalibrierung des Systems durchführen. In den meisten Fällen allerdings sind die Abweichungen durch Thermodrifts und kleine Erschütterungen sehr gering. Es genügt daher, einfach die Kalibrierungsmaske wieder in Position zu fahren und die Differenz der Ausrichtungsmarken, die man durch die obere beziehungsweise untere Optik misst, zu notieren. Dieser "Offset" muss bei der Ausrichtung späterer Wafer natürlich berücksichtigt werden. Meistens gibt man einen solchen Offsetwert in der Software an, mit welcher die erfindungsgemäße Ausführungsform betrieben wird. Die Software sorgt dann dafür, dass er untere und/oder obere Probenhalter entsprechend um den "Offset" Wert weiter in +x/-x bzw. +y/-y Richtung verfährt. Dem Fachmann auf dem Gebiet ist die zu Grund liegende Problematik und die Technik um sie zu beherrschen allerdings bekannt.

Nachdem die Kalibrierung für die mindestens zwei Erfassungseinheiten durchgeführt wurde, sind zwei X-Y-Referenzpositionen erfasst, bezüglich deren eine Steuerung der Translations- und Rotationsbewegung der Substrate erfolgen kann. Die Steuerung der Bewegung der Substrate und/oder Erfassungsmittel erfolgt mittels einer, insbesondere softwaregestützten, Steuerungseinrichtung.

Der Vollständigkeit halber sei daher erwähnt, dass die Koinzidenz des Schnittpunktes der optischen Achsen mit den Ausrichtungsmarken des Kalibrierungssubstrats zwar vorteilhaft, aber nicht nötig ist, um erfindungsgemäße Berechnungen durchzuführen, solange die Distanz zwischen den Schnittpunkten der optischen Achse mit der Fokusebene, in der sich die späteren Ausrichtungsmarken der zueinander zu orientierenden Substrate befinden, bekannt sind.

Durch die Erfindung ist es, insbesondere nach einer Kalibrierung des Systems, möglich, ein erstes Substrat auf eine erste Aufnahme (Probenhalter) und ein zweites Substrat auf eine zweite Aufnahme zu fixieren. Die erste und die zweite Aufnahme fahren die beiden fixierten Substrate, insbesondere gleichzeitig und/oder symmetrisch, jeweils in unterschiedliche, separate, insbesondere seitlich gegenüberliegend zu der Ausrichtungseinheit angeordnete, Erfassungspositionen.

Danach erfasst/vermisst die jeweilige Erfassungseinheit, in deren Sichtfeld sich eine Ausrichtungsmarkierung befindet, die X-Y-Position der Ausrichtungsmarkierung. Nach der Erfassung erfolgt eine Messung der jeweils gegenüberliegenden Ausrichtungsmarkierungen der beiden Substrate, sodass die jeweils beim ersten Messvorgang nicht messende Erfassungseinheit die jeweils andere, im ersten Messvorgang nicht erfasste Ausrichtungsmarkierung, erfasst. Es sind erfindungsgemäß insbesondere zwei Erfassungsschritte hintereinander vorgesehen, die jeweils zwei Ausrichtungsmarkierungen in einem Schritt erfassen.

Aus den so ermittelten acht Messwerten, jeweils eine X- und eine Y-Position für jeweils vier Ausrichtungsmarkierungen, kann die X-Y-Position der beiden Substrate bestimmt werden. Die obere und untere Justiereinheit sorgen anschließend dafür, dass die beiden Aufnahmen und damit die Substrate in die jeweilige Ausrichtungsposition fahren. Danach erfolgt ein Kontaktieren der beiden Substrate durch eine relative Annäherung der beiden Substrate zueinander. Diese erfolgt durch eine Bewegung des oberen und/oder unteren Probenhalters in Z-Richtung aufeinander zu.

In einer vorteilhaften Erfindung ist es vorgesehen, eine der beiden Aufnahmen während der relativen Annäherung nicht zu bewegen oder relativ zu der Ausrichtungseinheit zu fixieren, um einen etwaigen Translationsfehler auf eine Bewegungsachse und einen Bewegungsmotor zu beschränken.

Der Erfindung liegt also vor allem der Gedanke zu Grunde, die für den Ausrichtungsprozess nötigen Erfassungsmittel so zu positionieren, dass jeweils zwei aufeinander zu gerichtete Erfassungsgeräte, insbesondere an jeweils gegenüberliegenden Seite der Ausrichtungseinheit, die X-Y-Positionen von Ausrichtungsmarkierungen der Substrate erfassen. In dem erfindungsgemäßen Verfahren wird dadurch der Verfahrweg der beiden Substrate minimiert.

Soweit sich im erfindungsgemäßen Verfahren die beiden Aufnahmen insbesondere ausschließlich entlang der X-Achse bewegen, können Translationseinheiten mit einer sehr hohen Genauigkeit und Reproduzierbarkeit verwendet werden. Soweit ein Drift in einer Y-Richtung erfolgt, ist dieser mit Vorteil erfindungsgemäß messbar und kompensierbar.

Erfindungsgemäß wird ein Abstand der Substrate in Z-Richtung vor der Erfassung bis zur Ausrichtung konstant eingestellt und/oder minimiert, insbesondere kleiner als 1cm, vorzugsweise kleiner als 1 mm, noch bevorzugter kleiner als 100µm.

Der Vorteil der Erfindung liegt vor allem darin, dass die Vorrichtung auch im Vakuum betrieben werden kann. Durch die erfindungsgemäß verhältnismäßig kurzen Verfahrwege der oberen und/oder unteren Aufnahme und damit des ersten (unteren) und/oder zweiten (oberen) Substrats können mechanische Bauteile für Schlitten/Lager/Schrittmotoren verwendet werden, die vakuumtauglich sind. Damit ist es erstmals möglich, ein Bondmodul und ein Ausrichtungsmodul in einem Vakuumcluster, mit Vorzug einem Hochvakuumcluster, zu installieren und den Substrattransport von dem Ausrichtungsmodul zum Bondmodul innerhalb eines evakuierbaren Bereiches durchzuführen, ohne das Substrat wieder einer Atmosphäre auszusetzen.

Ein weiterer Vorteil liegt in der Verwendungsmöglichkeit von sichtbarem Licht. Auf die Verwendung von Transmissionstechniken kann erfindungsgemäß verzichtet werden. Des Weiteren können alle Substrate, auch für den breiten Bereich des elektromagnetischen Spektrums opake Substrate, vermessen werden, da die Ausrichtungsmarkierungen auf den Oberflächen auffindbar sind, ohne das Substrat durchleuchten zu müssen.

In allen Figuren werden die Justiereinheiten immer innerhalb des Gehäuses dargestellt. Denkbar wäre natürlich auch, dass die Justiereinheiten sich außerhalb des Gehäuses befinden und durch entsprechende Vakuumdurchführungen die Probenhalter die sich innerhalb des Gehäuses befinden, zu steuern. Dasselbe gilt auch für die Erfassungsmittel. In der optimalsten, aber technisch natürlich schwer zu realisierenden, Ausführungsform würden sich nur die beiden zueinander auszurichtenden Substrate im Vakuum befinden.

Die erfindungsgemäße Ausführungsform wird mit Vorzug in einem Vakuumcluster, mit noch größerem Vorzug in einem Hochvakuumcluster, mit größtem Vorzug in einem Ultrahochvakuumcluster, zusammen mit anderen Modulen verwendet. Bei den anderen Modulen kann es sich beispielsweise um eines oder mehrere der folgenden Module handeln
- Heizmodul
- Kühlmodul
- Belackungsmodul
- Bondmodul
- Debondmodul
- Inspektionsmodul
- Laminierungsmodul
- Oberflächenbehanldungsmodul
- Plasmamodul

In einer besonderen Ausführungsform werden die, in der erfindungsgemäßen Ausführungsform zueinander ausgerichteten, Substrate mit einer in Patentschrift PCT/EP2013/056620 erwähnten Methode zueinander geklemmt, auf die Bezug genommen wird. Die Klemmmethode verwendet kleine Magnetkörper zur schnellen, effizienten und leichten Fixierung der beiden zueinander ausgerichteten und in Kontakt gebrachten Substrate. Die beiden Substrate können auch über molekulare Kräfte vorfixiert werden. Die Klemmung kann aber auch rein mechanisch erfolgen.

Soweit vorliegend und/oder in der anschließenden Figurenbeschreibung Vorrichtungsmerkmale offenbart sind, sollen diese auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: eine schematische, perspektivische Außendarstellung einer Ausführungsform der erfindungsgemäßen Vorrichtung,
- Figur 1b: eine schematische Querschnittsdarstellung der Ausführungsform gemäß Figur 1a,
- Figur 2a: eine schematische Querschnittsdarstellung der Ausführungsform gemäß Figur 1a mit einem geladenen Kalibriersubstrat in einem ersten Kalibrierungsschritt,
- Figur 2b: eine schematische Querschnittsdarstellung der Ausführungsform gemäß Figur 1a mit einem geladenen Kalibriersubstrat in einem zweiten Kalibrierungsschritt,
- Figur 2c: eine schematische Vergrößerung dreier möglicher Kalibriersituationen im Kalibrierungsschritt gemäß Figur 2b,
- Figur 2d: eine schematische Querschnittsdarstellung der Ausführungsform gemäß Figur 1a mit einem geladenen Kalibriersubstrat in einem dritten Kalibrierungsschritt,
- Figur 2e: eine schematische Vergrößerung dreier möglicher Kalibriersituationen im Kalibrierungsschritt gemäß Figur 2d,
- Figur 3a: eine schematische Querschnittsdarstellung der Ausführungsform gemäß Figur 1a mit zwei geladenen Substraten in einem ersten Verfahrensschritt des erfindungsgemäßen Verfahrens,
- Figur 3b: eine schematische Querschnittsdarstellung der Ausführungsform gemäß Figur 1a mit zwei geladenen Substraten in einem zweiten Verfahrensschritt des erfindungsgemäßen Verfahrens,
- Figur 3c: eine schematische, Querschnittsdarstellung der Ausführungsform gemäß Figur 1a mit zwei geladenen Substraten in einem dritten Verfahrensschritt des erfindungsgemäßen Verfahrens,
- Figur 3d: eine schematische, Querschnittsdarstellung der Ausführungsform gemäß Figur 1a mit zwei geladenen Substraten in einem vierten Verfahrensschritt des erfindungsgemäßen Verfahrens,
- Figur 4a: eine schematische Ansicht von Sichtfeldern von Erfassungsmitteln in einem ersten Kalibrierschritt einer ersten Erfassungseinheit,
- Figur 4b: Eine schematische Ansicht von Sichtfeldern der Erfassungsmittel in einem zweiten Kalibrierschritt der ersten Erfassungseinheit,
- Figur 4c: Eine schematische Ansicht von Sichtfeldern der Erfassungsmittel in einem dritten Kalibrierschritt der ersten Erfassungseinheit,
- Figur 4d: Eine schematische Ansicht von Sichtfeldern der Erfassungsmittel in einem ersten Kalibrierschritt einer zweiten Erfassungseinheit,
- Figur 4e: Eine schematische Ansicht von Sichtfeldern der Erfassungsmittel in einem zweiten Kalibrierschritt der zweiten Erfassungseinheit und
- Figur 4f: Eine schematische Ansicht von Sichtfeldern der Erfassungsmittel in einem dritten Kalibrierschritt der zweiten Erfassungseinheit.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

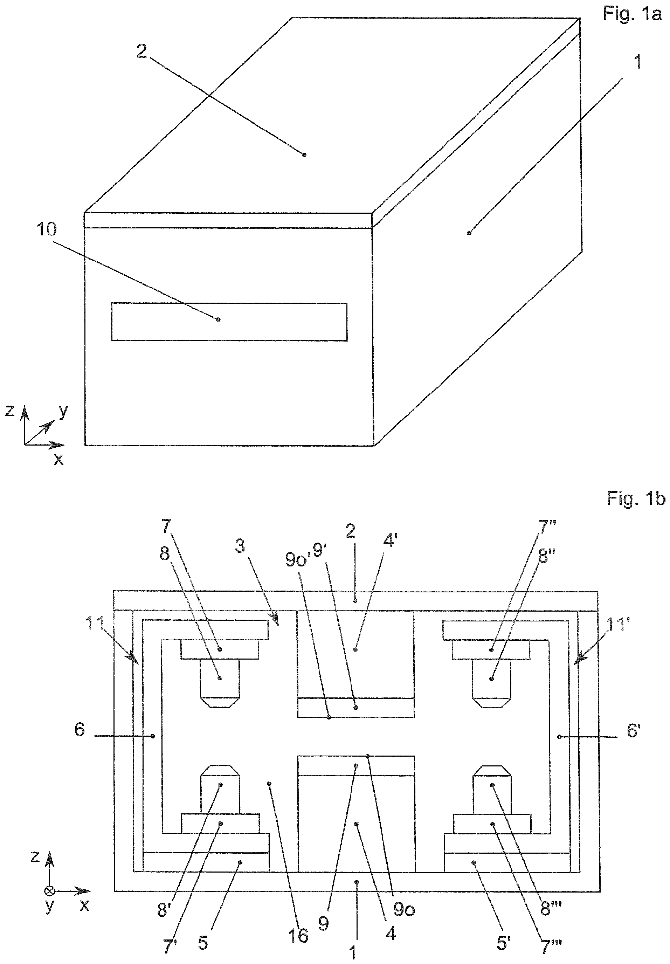

Die Figur 1 zeigt eine Ausführungsform der erfindungsgemäßen Vorrichtung. Die zur Ausführung des erfindungsgemäßen Verfahrens notwendigen Komponenten werden mit Vorzug in einem vakuumdichten Gehäuse 1, welches von einer Seite über einen Deckel 2 geöffnet und vakuumdicht verschlossen werden kann, angeordnet. Die Beladung und Entladung von zueinander auszurichtenden ersten Substraten 15 und zweiten Substraten 15' erfolgt dabei mit Vorzug durch ein Schleusentor 10. Das Schleusentor 10 ist vakuumdicht und trennt einen durch das Gehäuse 1 und den Deckel 2 gebildeten Innenraum 16 von der umgebenden Atmosphäre.

Sollten zwischen dem Innenraum 16 und der umgebenden Atmosphäre unterschiedliche Druckverhältnisse herrschen, so kann dem Schleusentor 10 eine Schleuse (nicht dargestellt) vor- und/oder nachgeschaltet werden.

Der Deckel 2 dient vorzugsweise dem leichten Zugang zum Innenraum 16. In speziellen Ausführungsformen können die Substrate 15, 15' statt über das Schleusentor 10 über den Deckel 2 beladen und entladen werden, wobei auf das Schleusentor 10 verzichtet werden kann.

Im Zentrum des Gehäuses 1 ist eine Ausrichtungseinheit 3 angeordnet, die eine erste Justiereinheit 4 und eine zweite Justiereinheit 4' aufweist. An der ersten Justiereinheit 4 ist eine erste Aufnahme 9 angebracht, die mittels der ersten Justiereinheit 4 bewegt werden kann. Die Bewegung wird durch eine Steuerungseinheit gesteuert. Die erste Justiereinheit 4 ist auf dem Boden des Gehäuses 1 fixiert. An der zweiten Justiereinheit 4' ist eine zweite Aufnahme 9' angebracht, die mittels der zweiten Justiereinheit 4' bewegt werden kann. Die Bewegung wird ebenfalls durch die Steuerungseinheit gesteuert. Die zweite Justiereinheit 4' ist am Deckel 2 fixiert.

Eine erste Aufnahmefläche 9o der ersten Aufnahme 9 ist gegenüberliegend zu einer zweiten Aufnahmefläche 9o' der zweiten Aufnahme 9' angeordnet und parallel zu der ersten Aufnahmefläche 9o ausrichtbar. Die erste Aufnahme 9 dient zur Aufnahme und Fixierung des ersten Substrats 15 an der ersten Kontaktfläche 9o und die zweite Aufnahme 9' dient zur Aufnahme und Fixierung des zweiten Substrats 15' an der zweiten Kontaktfläche 9o'. Die erste Kontaktfläche 9o definiert eine erste Kontaktebene und die zweite Kontaktfläche 9o' bildet eine zweite Kontaktebene. Bei paralleler Ausrichtung definieren die Kontaktflächen 9o, 9o' eine X-Y-Ebene mit einer X-Richtung und einer Y-Richtung sowie eine dazu orthogonal verlaufende Z-Richtung.

An zwei gegenüberliegenden Seiten der Ausrichtungseinheit 3 sind eine erste Erfassungseinheit 11 und eine zweite Erfassungseinheit 11' angeordnet. Jede Erfassungseinheit 11, 11' besteht aus einer ersten und einer zweiten Fixierungstranslationseinheit 5, 5', jeweils einer darauf montierten ersten und zweiten Optikfixierung 6, 6'.

Die Optikfixierungen 6, 6' sind U-förmig ausgebildet, wobei Schenkel 6u, 6o, 6u', 6o' jeweils von Böden 6b, 6b' in Richtung der Ausrichtungseinheit 3 ausgerichtet oder ausrichtbar sind, insbesondere parallel zu der X-Y-Ebene angeordnet oder anordenbar.

An den Optikfixierungen 6, 6' sind jeweils über Optiktranslationseinheiten 7, 7', 7", 7'" bewegbare Erfassungsgeräte 8, 8', 8", 8"' montiert, die jeweils paarweise gegenüberliegend angeordnet oder anordenbar sind. Die Erfassungsgeräte 8, 8', 8", 8'" sind vorzugsweise als Optiken ausgebildet.

Die Fixierungstranslationseinheiten 5, 5' dienen jeweils der weiträumigen Bewegung der sich darauf befindenden Optikfixierungen 6, 6'. Durch die Ansteuerung der Fixierungstranslationseinheiten 5, 5' können zwei bereits zueinander kalibrierte Erfassungsgeräte 8, 8' bzw. 8", 8'" translatorisch bewegt werden, ohne ihre Kalibrierung zu verlieren.

Die Optiktranslationseinheiten 7, 7', 7", 7'" dienen hingegen der Bewegung der Erfassungsgeräte 8, 8', 8", 8"', insbesondere zur Kalibrierung der Erfassungsgeräte 8, 8', 8", 8'" auf einen Punkt einer, insbesondere gemeinsamen, Fokusebene. Die Fokusebenen werden durch Fokussierung der Erfassungsgeräte 8, 8', 8", 8'" definiert, wobei Fokusebene insbesondere einen Fokusebenenkorridor umfasst. Gemeinsam heißt insbesondere eine Fokusebene je eines Erfassungsgerätepaares aus zwei Erfassungsgeräten 8, 8' bzw. 8", 8'" an jeder Erfassungseinheit 11, 11' separat, vorzugsweise von allen Erfassungsgeräten 8, 8', 8", 8'" der Erfassungseinheiten 11, 11'. Bevorzugt liegen die Fokusebenen parallel zu der ersten Kontaktebene und/oder der zweiten Kontaktebene und/oder der X-Y-Ebene. Insbesondere liegen die Fokusebenen zwischen der ersten und zweiten Kontaktebene.

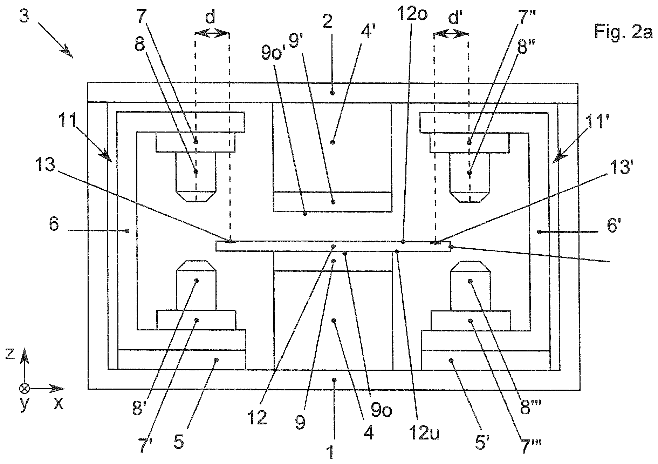

In einem ersten Kalibrierschritt wird ein auf einer Oberseite 12o auf gegenüberliegenden Seiten angeordnete Ausrichtungsmarken 13, 13' aufweisendes Kalibriersubstrat 12 auf der ersten Aufnahme 9 aufgenommen und fixiert. Die Ausrichtungsmarken 13, 13' sind vorzugsweise in einem Umfangsbereich angeordnet, der näher an einer seitlichen Umfangskontur 12k als an einem Schwerpunkt des Kalibriersubstrats 12 liegt, insbesondere mindestens zweimal so nah, vorzugsweise mindestens viermal so nah. Das Kalibriersubstrat 12 ist mit Vorzug transparent, damit die seitlich der ersten Aufnahme angeordneten Erfassungsgeräte 8', 8'" die Ausrichtungsmarken 13, 13' von einer der Oberseite 12o abgewandten Unterseite 12u her vermessen können (Figur 2a).

In der Ausrichtungsposition ist die erste Ausrichtungsmarke 13 in X-Richtung um einen Abstand d von den optischen Achsen 14, 14' der ersten Erfassungseinheit 11 entfernt, während die zweite Ausrichtungsmarke 13' in X-Richtung um einen, insbesondere dem Abstand d entsprechenden, Abstand d' von den optischen Achsen 14", 14'" der zweiten Erfassungseinheit 11' entfernt ist.

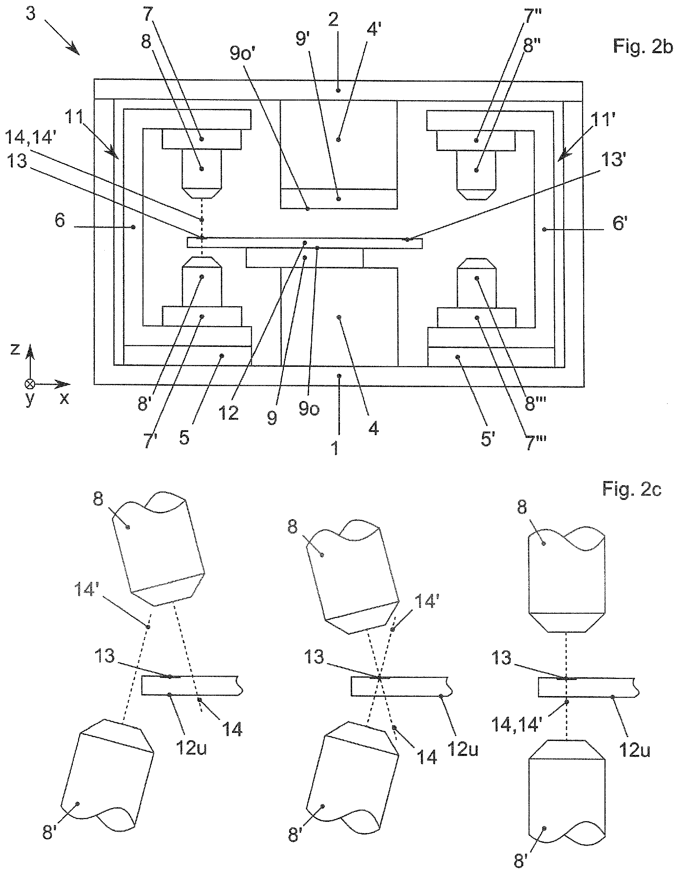

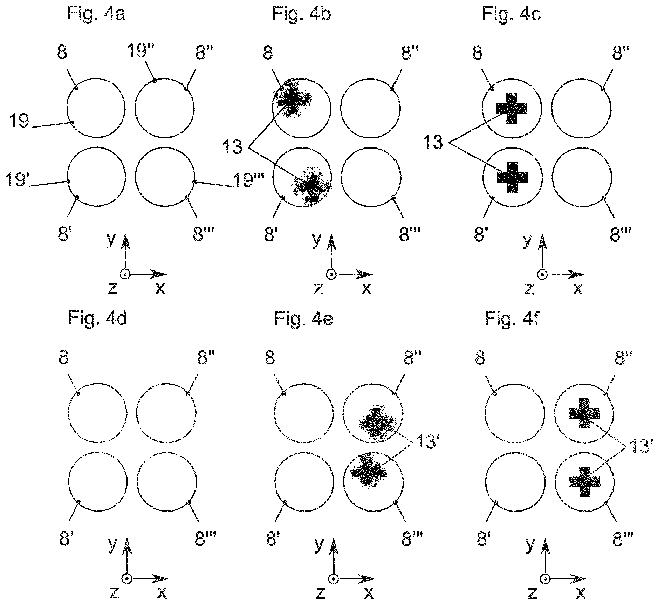

In einem zweiten Kalibrierungsschritt gemäß Figur 2b wird die erste Aufnahme 9 durch die erste Justiereinrichtung 4 in X-Richtung entlang der X-Y-Ebene um einen dem Abstand d entsprechenden Verfahrweg in eine erste Kalibrierposition gefahren, in der die erste Ausrichtungsmarke 13 in Sichtfeldern 19, 19' (siehe Figuren 4a bis 4f) der beiden Erfassungsgeräte 8, 8' der ersten Erfassungseinheit 11 liegt.

Soweit ein Schnittpunkt der beiden optischen Achsen 14, 14' der Erfassungsgeräte 8, 8' nicht in der ersten Ausrichtungsmarke 13 liegt, werden die beiden Erfassungsgeräte 8, 8' mittels der Optiktranslationseinheiten 7, 7' verfahren, bis der Schnittpunkt der beiden optischen Achsen 14, 14' mit der ersten Ausrichtungsmarke 13 des Kalibriersubstrats 12 deckungsgleich ist (siehe Figur 2c Mitte). In einer besonders vorteilhaften Ausführungsform werden die beiden optischen Achsen 14, 14' mittels der Optiktranslationseinheiten 7, 7' kollinear zueinander ausgerichtet (Fig. 2c, rechts).

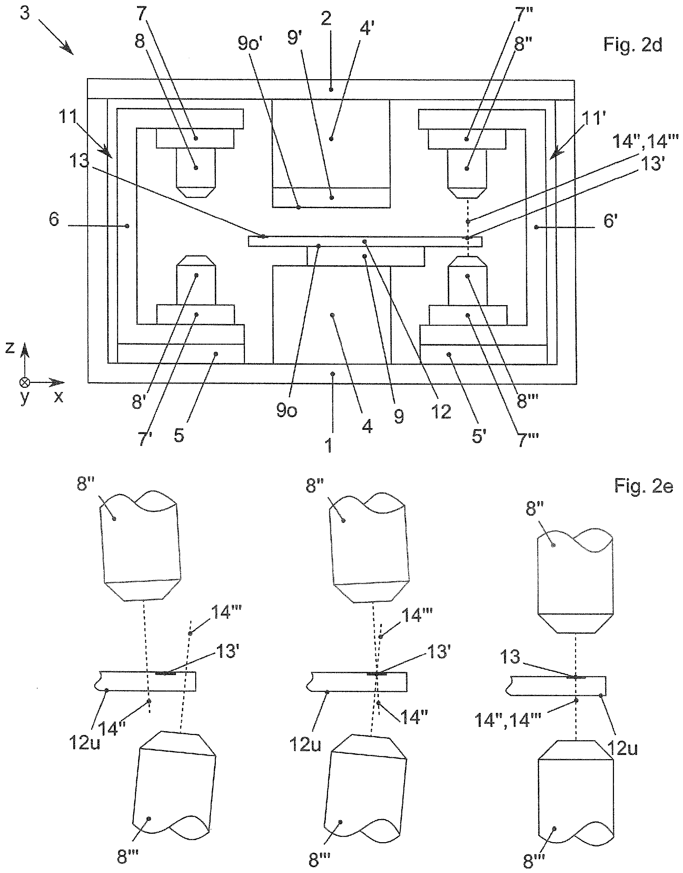

In einem dritten Kalibrierschritt wird die erste Aufnahme 9 durch die erste Justiereinrichtung 4 in X-Richtung entlang der X-Y-Ebene um einen dem Abstand d' entsprechenden Verfahrweg in eine zur ersten Kalibrierposition gegenüberliegende zweite Kalibrierposition gefahren, um die zweite Ausrichtungsmarke 13' in die Sichtfelder 19", 19'" der beiden Erfassungsgeräte 8", 8'" der zweiten Erfassungseinheit 11' zu bringen (Figur 2d).

Soweit ein Schnittpunkt der beiden optischen Achsen 14", 14"' der Erfassungsgeräte 8", 8'" nicht in der zweiten Ausrichtungsmarke 13' liegt, werden die beiden Erfassungsgeräte 8", 8"" mittels der Optiktranslationseinheiten 7", 7'" verfahren, bis der Schnittpunkt der beiden optischen Achsen 14", 14" mit der zweiten Ausrichtungsmarke 13' des Kalibriersubstrats 12 deckungsgleich ist (Fig. 2e Mitte). In einer besonders vorteilhaften Ausführungsform werden die beiden optischen Achsen 14", 14"'mittels der Optiktranslationseinheiten 7", 7'" kollinear zueinander ausgerichtet (Fig. 2e, rechts).

Das Kalibrierverfahren kann auch aus der Sicht der Erfassungsgeräte 8, 8', 8", 8"' mit den jeweiligen Sichtfeldern 19, 19', 19", 19'" betrachtet werden. Die Figuren 4a-4f zeigen die oben beschriebenen Kalibrierschritte. Im ersten Kalibrierschritt liegen die Ausrichtungsmarken 13. 13' nicht in den Sichtfeldern 19, 19', 19", 19"', so dass diese leer sind (siehe Figuren 4a, 4d).

Im zweiten Kalibrierschritt wird die Ausrichtungsmarke 13 in die Sichtfelder 19, 19' der beiden Optiken 8, 8' bewegt (Figur 4b). Soweit die Ausrichtungsmarke 13 in den Sichtfeldern 19, 19' unscharf und/oder nicht zentriert abgebildet ist, wird durch translatorische und/oder rotatorische Verstellung der jeweiligen Erfassungsgeräte 8, 8' durch die zugeordneten Optiktranslationseinheiten 7, 7' und/oder Fokussierung scharfgestellt und/oder zentriert (siehe Figur 4c). Dies wird durch die Steuerungseinrichtung gesteuert.

Analog zum zweiten Kalibrierschritt läuft der dritte Kalibrierschritt auf der gegenüberliegenden Seite mit der Erfassungseinheit 11' (siehe Figuren 4e, 4f).

Die im Kalibrierverfahren ermittelten Daten, insbesondere X-, Y- und/oder Z-Positionen der Fokusebene(n) und der Schnittpunkte der optischen Achsen 14, 14', 14", 14'" werden in der Steuerungseinrichtung für die Berechnung/Steuerung des nachfolgend beschriebenen, erfindungsgemäßen Verfahrens verwendet.

In einem erfindungsgemäß ersten Ausrichtungsschritt wird das erste Substrat 15 auf die erste Aufnahme 9 geladen und fixiert und das zweite Substrat 15' wird auf die zweite Aufnahme 9' geladen und fixiert. Das erste Substrat 15 weist zwei, insbesondere am Seitenumfang gegenüberliegend angeordnete, Ausrichtungsmarkierungen 20, 20' auf. Das zweite Substrat 15' weist zwei, insbesondere am Seitenumfang gegenüberliegend angeordnete, insbesondere zu den Ausrichtungsmarkierungen 20, 20' korrespondierende Ausrichtungsmarkierungen 20", 20'" auf. Die Ausrichtungsmarkierungen 20, 20', 20", 20"' sind vorzugsweise in einem Umfangsbereich angeordnet, der näher an einer seitlichen Umfangskontur 15k, 15k' der Substrate 15, 15' als an einem Schwerpunkt der Substrate 15, 15' liegt, insbesondere mindestens zweimal so nah, vorzugsweise mindestens viermal so nah. Zwischen dem ersten Substrat 15 und dem hierzu mittels der Justiereinrichtungen 4, 4' parallel ausgerichteten zweiten Substrat 15' wird ein vorgegebener Abstand A von weniger als 1mm eingestellt.

In der Ausrichtungsposition sind die Ausrichtungsmarkierungen 20, 20' in X-Richtung um einen Abstand D von den optischen Achsen 14, 14' der ersten Erfassungseinheit 11 entfernt, während die Ausrichtungsmarkierungen 20", 20'" in X-Richtung um einen, insbesondere dem Abstand D entsprechenden, Abstand D' von den optischen Achsen 14", 14"' der zweiten Erfassungseinheit 11' entfernt sind.

Die Abstände d, d' des Kalibriersubstrats 12 weichen vorzugsweise von den Abständen D, D' um weniger als den Durchmesser der Sichtfelder 19, 19', 19", 19"' ab.

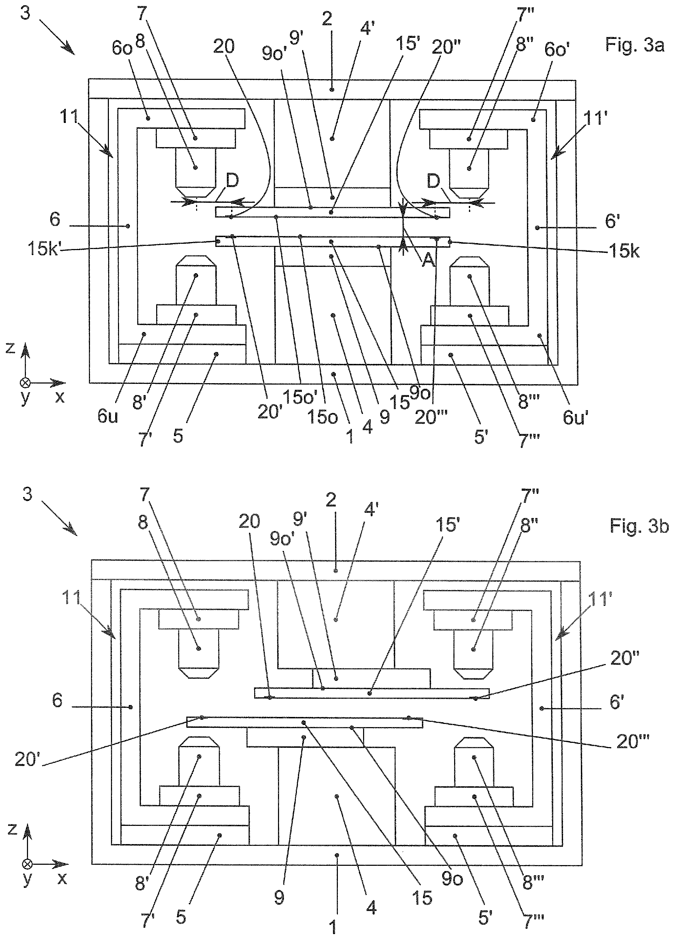

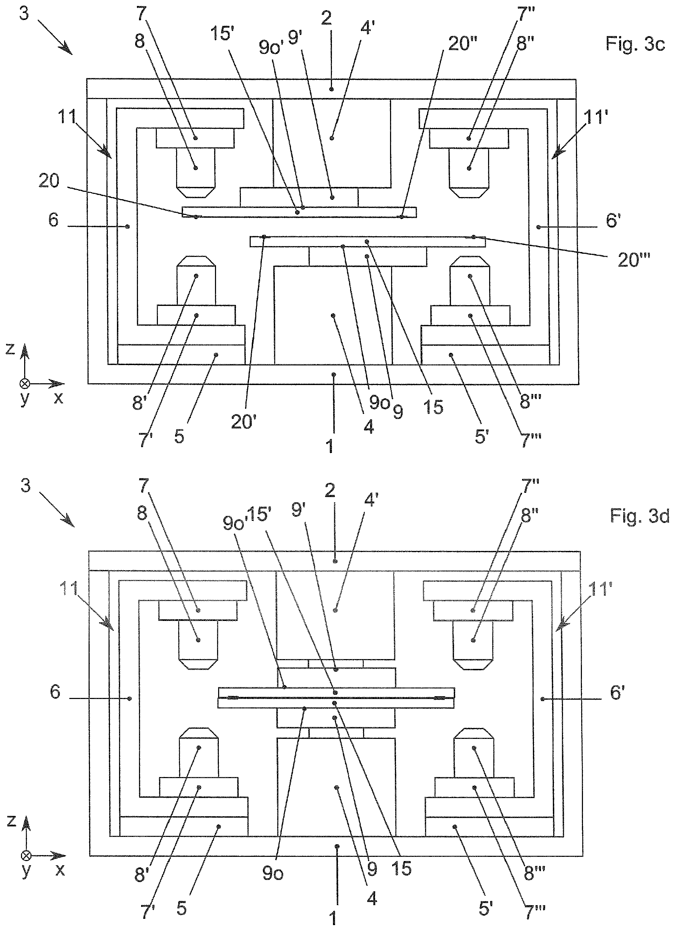

In einem erfindungsgemäßen zweiten Ausrichtungsschritt wird die erste Aufnahme 9 zu der ersten Erfassungseinheit 11 (in der Abbildung gemäß Figur 3b links) in eine erste Erfassungsposition und die zweite Aufnahme 9', insbesondere gleichzeitig, zu der zweiten Erfassungseinheit 11' (in der Abbildung gemäß Figur 3b rechts) in eine zweite, gegenüberliegend zu der ersten Erfassungsposition angeordnete, Erfassungsposition gefahren. Die Ausrichtungsmarkierung 20' des ersten Substrats 15 und die Ausrichtungsmarkierung 20" des zweiten Substrats 15' werden durch die Erfassungsgeräte 8', 8" erfasst, indem diese in der jeweiligen Erfassungsposition im jeweiligen Sichtfeld 19', 19" der optischen Achsen 14', 14"zu liegen kommen.

In einem erfindungsgemäßen dritten Ausrichtungsschritt wird die erste Aufnahme 9 zu der zweiten Erfassungseinheit 11' (in der Abbildung gemäß Figur 3b rechts) in die zweite Erfassungsposition und die zweite Aufnahme 9', insbesondere gleichzeitig, zu der ersten Erfassungseinheit 11 (in der Abbildung gemäß Figur 3b links) in die erste Erfassungsposition gefahren. Die Ausrichtungsmarkierungen 20'" des ersten Substrats 15 und die Ausrichtungsmarkierung 20 des zweiten Substrats 15' werden durch die Erfassungsgeräte 8"', 8 erfasst, indem diese in der jeweiligen Erfassungsposition im jeweiligen Sichtfeld 19"', 19 der optischen Achsen 14'", 14 zu liegen kommen.

Die X-, Y- und/oder Z-Positionen der Substrate 15, 15' aus den zweiten und dritten Ausrichtungsschritten werden durch die auf die Erfassungseinheiten 11, 11' kalibrierten Justiereinheiten 4, 4' registriert. Aus den X-, Y- und/oder Z-Positionen lässt sich außerdem die Rotationslage der Substrate 15, 15' ermitteln. Weiterhin werden aus den X-, Y- und/oder Z-Positionen die Ausrichtungspositionen der Substrate 15, 15' berechnet.

In einem erfindungsgemäßen vierten Ausrichtungsschritt werden die Substrate 15, 15' durch die Justiereinheiten 4, 4' an die ermittelten Ausrichtungspositionen gefahren. Danach erfolgt die Kontaktierung durch Annäherung der Kontaktflächen 15o, 15o' in Z-Richtung (siehe Figur 3d).

Der erfindungsgemäße Gedanke liegt also vor allem in den relativ kurzen Verfahrwegen zwischen den Erfassungspositionen und den Ausrichtungspositionen, wodurch Positionierfehler minimiert werden.

### Vorrichtung und Verfahren zum Ausrichten von Substraten

**Bezugszeichenliste**

| | |
|---|---|
| 1 | Gehäuse |
| 2 | Deckel |
| 3 | Ausrichtungseinheit |
| 4, 4` | erste und zweite Justiereinheit |
| 5, 5' | erste und zweite Fixierungstranslationseinheit |
| 6, 6' | erste und zweite Optikfixierung |
| 6u, 6u', 6o, 6o' | Schenkel |
| 7, 7', 7", 7'" | Optiktranslationseinheit |
| 8, 8', 8", 8"' | Erfassungsgerät |
| 9, 9' | erste und zweite Aufnahmen |
| 10 | Schleusentor |
| 11, 11' | erste und zweite Optische Einheit |
| 12 | Kalibriersubstrat |
| 12o | Oberseite |
| 12u | Unterseite |
| 12k | seitliche Umfangskontur |
| 13, 13' | erste und zweite Ausrichtungsmarken |
| 14, 14', 14", 14'" | Optische Achsen |
| 15, 15' | erste und zweite Substrate |
| 15o, 15o' | erste und zweite Kontaktflächen |
| 15k, 15k' | seitliche Umfangskonturen |
| 16 | Innenraum |
| 19, 19', 19", 19'" | Sichtfelder |
| 20, 20', 20", 20" | Ausrichtungsmarkierungen |
| A | Abstand |
| d, d' | Abstand |
| D, D' | Abstand |

## Patentansprüche

1. Verfahren zum Ausrichten und Kontaktieren eines ersten Substrats (15) mit einem zweiten Substrat (15') mit folgendem Ablauf:
- Fixierung des ersten Substrats (15) auf einer ersten Aufnahme (9) und des zweiten Substrats (15') auf einer zweiten Aufnahme (9'), die der ersten Aufnahme (9) gegenüberliegend angeordnet ist, wobei das erste und zweite Substrat (15, 15') zwischen der ersten und zweiten Aufnahme (9, 9') mit einem Abstand A zwischen einer ersten Kontaktfläche (15o) des ersten Substrats (15) und einer zweiten Kontaktfläche (15o') des zweiten Substrats (15) in einer Z-Richtung angeordnet werden,
- Verfahren der ersten Aufnahme (9) zu einer ersten Erfassungseinheit (11) in eine erste Erfassungsposition und der zweiten Aufnahme (9') zu einer zweiten Erfassungseinheit (11') in eine gegenüberliegend der ersten Erfassungsposition angeordneten zweiten Erfassungsposition,
- Erfassung einer ersten X-Y-Position einer in einem Umfangsbereich des ersten Substrats (15) angeordneten ersten Ausrichtungsmarkierung (20) in der in einer X- und/oder Y-Richtung entlang der ersten Kontaktfläche (15o) verfahrenen ersten Erfassungsposition,
- Erfassung einer zweiten X-Y-Position einer in einem Umfangsbereich des zweiten Substrats (15') angeordneten zweiten Ausrichtungsmarkierung (20') in der in einer X- und/oder Y-Richtung entlang der zweiten Kontaktfläche (15o') verfahrenen zweiten Erfassungsposition,
- Verfahren der ersten Aufnahme (9) zur zweiten Erfassungseinheit (11') in die zweite Erfassungsposition und der zweiten Aufnahme (9') zur ersten Erfassungseinheit (11) in die erste Erfassungsposition,
- Erfassung einer dritten X-Y-Position einer in einem Umfangsbereich des ersten Substrats (15) angeordneten dritten Ausrichtungsmarkierung (20") in der zweiten Erfassungsposition,
- Erfassung einer vierten X-Y-Position einer in einem Umfangsbereich des zweiten Substrats (15') angeordneten vierten Ausrichtungsmarkierung (20'") in der ersten Erfassungsposition,
- Ausrichtung des ersten Substrats (15) gegenüber dem zweiten Substrat (15') durch Justiereinheiten (4, 4') auf Basis der durch die Erfassungen erfassten ersten, zweiten, dritten und vierten X-Y-Positionen und
- Kontaktierung des gegenüber dem zweiten Substrat (15') ausgerichteten ersten Substrats (15) mit dem zweiten Substrat (15').

2. Verfahren nach Anspruch 1, bei dem die erste und vierte Ausrichtungsmarkierung (20', 20) und/oder die zweite und dritte Ausrichtungsmarkierung (20", 20") in Z-Richtung gegenüberliegend angeordnet sind.

3. Verfahren nach Anspruch 1 oder 2, bei dem die Erfassung der erste und zweite Ausrichtungsmarkierung (20', 20") und/oder die Erfassung der dritten und vierten Ausrichtungsmarkierung (20", 20"') in einem zusammenhängenden Verfahrensschritt, insbesondere gleichzeitig, insbesondere mit einer ersten Erfassungseinheit (11) zur Erfassung der ersten und/oder zweiten Ausrichtungsmarkierungen (20', 20") und einer zweiten Erfassungseinheit (11') zur Erfassung der dritten und/oder vierten Ausrichtungsmarkierungen(20", 20"'), erfolgt.

4. Vorrichtung zum Ausrichten und Kontaktieren eines ersten Substrats (15) mit einem zweiten Substrat (15') mit:
- einer ersten Aufnahme (9) zur Fixierung des ersten Substrats (15) und einer der ersten Aufnahme (9) gegenüberliegend angeordneten zweiten Aufnahme (9') zur Fixierung des zweiten Substrats (15'), wobei das erste und zweite Substrat (15, 15') zwischen der ersten und zweiten Aufnahme (9, 9') mit einem Abstand zwischen einer ersten Kontaktfläche des ersten Substrats (15) und einer zweiten Kontaktfläche des zweiten Substrats (15) in einer Z-Richtung anordenbar sind,
- einer ersten Justiereinheit (4) zum Verfahren der ersten Aufnahme (9) zumindest in einer quer zur Z-Richtung verlaufenden X- und/oder Y-Richtung,
- einer zweiten Justiereinheit (4') zum Verfahren der zweiten Aufnahme (9') zumindest in X- und/oder Y-Richtung,
- Erfassungsmitteln (8, 8', 8", 8"') zur
a) Erfassung einer ersten X-Y-Position einer in einem Umfangsbereich des ersten Substrats (15) angeordneten ersten Ausrichtungsmarkierung (20') in einer in einer X- und/oder Y-Richtung entlang einer ersten Kontaktfläche (15o) verfahrenen ersten Erfassungsposition,
b) Erfassung einer zweiten X-Y-Position einer in einem Umfangsbereich des zweiten Substrats (15') angeordneten zweiten Ausrichtungsmarkierung (20") in einer in einer X- und/oder Y-Richtung entlang einer zweiten Kontaktfläche (15k') verfahrenen zweiten Erfassungsposition,
c) Erfassung einer dritten X-Y-Position einer in einem Umfangsbereich des ersten Substrats (15) angeordneten dritten Ausrichtungsmarkierung (20"') in der zweiten Erfassungsposition und
d) Erfassung einer vierten X-Y-Position einer in einem Umfangsbereich des zweiten Substrats (15') angeordneten vierten Ausrichtungsmarkierung (20) in der ersten Erfassungsposition,
- Justiereinheiten (4, 4') zur Ausrichtung des ersten Substrats (15) gegenüber dem zweiten Substrat (15') auf Basis der durch die Erfassungen erfassten ersten, zweiten, dritten und vierten X-Y-Positionen,
- Kontaktierungsmittel zur Kontaktierung des gegenüber dem zweiten Substrat (15') ausgerichteten ersten Substrats (15) mit dem zweiten Substrat (15') in Z-Richtung, **dadurch gekennzeichnet, dass** die Vorrichtung eine Steuerungseinheit zur Ausführung eines Verfahrens gemäß Anspruch 1 umfasst.

5. Vorrichtung nach Anspruch 4, wobei die Kontaktierungmittel die erste und/oder die zweite Justiereinheit (4, 4') umfassen.

6. Vorrichtung nach Anspruch 4 oder 5, wobei die Erfassungsmittel eine erste Erfassungseinheit (11) zur Erfassung der ersten und/oder zweiten Ausrichtungsmarkierungen (20, 20') und eine zweite, insbesondere an einer zur ersten Erfassungseinheit (11) gegenüberliegenden Seite der Aufnahmen (9, 9') angeordnete, Erfassungseinheit (11') zur Erfassung der dritten und/oder vierten Ausrichtungsmarkierungen (20", 20'") aufweisen.

7. Vorrichtung nach Anspruch 6, wobei die erste Erfassungseinheit (11) mehrere elektromagnetisch arbeitende, insbesondere zwei gegenüberliegend angeordnete, erste Erfassungsgeräte (8, 8'), vorzugsweise Mikroskope, und/oder die zweite Erfassungseinheit (11') mehrere elektromagnetisch arbeitende, insbesondere zwei gegenüberliegend angeordnete, zweite Erfassungsgeräte (8", 8'"), vorzugsweise Mikroskope, aufweisen.

8. Vorrichtung nach Anspruch 7, wobei die erste Erfassungseinheit (11) eine erste Optikfixierung (6) zur Anbringung der ersten Erfassungsgeräte (8, 8') und/oder die zweite Erfassungseinheit (11') eine zweite Optikfixierung (6') zur Anbringung der zweiten Erfassungsgeräte (8", 8"') aufweist, und wobei die ersten Erfassungsgeräte (8, 8') durch eine die erste Optikfixierung (6) aufnehmende erste Fixierungstranslationseinheit (5) und/oder die zweiten Erfassungsgeräte (8", 8'") durch eine die zweite Optikfixierung (6') aufnehmende zweite Fixierungstranslationseinheit (5, 5') gemeinsam bewegbar sind.

9. Vorrichtung nach Anspruch 8, wobei die ersten Erfassungsgeräte (8, 8') jeweils separat über erste Optiktranslationseinheiten (7, 7') an der ersten Optikfixierung (6) bewegbar sind und/oder die zweiten Erfassungsgeräte (8", 8'") jeweils separat über zweite Optiktranslationseinheiten (7", 7"') an der zweiten Optikfixierung (6') bewegbar sind.

## Claims

1. A method for alignment and contact-making of a first substrate (15) with a second substrate (15') with the following sequences:
- fixing of the first substrate (15) on a first mount (9) and of the second substrate (15') on a second mount (9') which is located oppositely the first mount (9), the first and second substrate (15, 15') being located between the first and second mount (9, 9') with a distance A between a first contact surface (15o) of the first substrate (15) and a second contact surface (15o') of the second substrate (15) in a Z direction,
- moving the first mount (9) to a first detection unit (11) in a first detection position and the second mount (9') to a second detection unit (11') in a second detection position opposite to the first detection position,
- detecting a first X-Y position of a first alignment marking (20) located in a peripheral
region of the first substrate (15) in the first detection position which has moved in an X and/or Y direction along the first contact surface (15o),
- detecting a second X-Y position of a second alignment marking (20') located in a peripheral region of the second substrate (15') in the second detection position which has moved in an X and/or Y direction along the second contact surface (15o'),
- moving the first mount (9) to the second detection unit (11') in the second detection position and the second mount (9') to the first detection unit (11) in the first detection position,
- detecting a third X-Y position of a third alignment marking (20") located in a peripheral region of the first substrate (15) in the second detection position,
- detecting a fourth X-Y position of a fourth alignment marking (20"') located in a peripheral region of the second substrate (15') in the first detection position,
- aligning the first substrate (15) relative to the second substrate (15') by adjustment units (4, 4') based on the first, second, third and fourth X-Y positions which have been detected by the detections and
- contact-making of the first substrate (15), which has been aligned relative to the second substrate (15'), with the second substrate (15').

2. The method as claimed in Claim 1, wherein the first and fourth alignment marking (20', 20) and/or the second and third alignment marking (20'", 20") are arranged oppositely in the Z direction.

3. The method as claimed in Claim 1 or 2, wherein the detection of the first and second alignment marking (20', 20") and/or the detection of the third and fourth alignment marking (20", 20'") takes place in a coherent method step, especially at the same time, especially with a first detection unit (11) for detection of the first and/or second alignment markings (20', 20") and a second detection unit (11') for detection of the third and/or fourth alignment markings (20", 20"').

4. A device for aligning and contact-making of a first substrate (15) with a second substrate (15') with:
- a first mount (9) for fixing of the first substrate (15) and a second mount (9') located oppositely the first mount (9) for fixing of the second substrate (15'), the first and second substrate (15, 15') being able to be located between the first and second mount (9, 9') with a distance between a first contact surface (15o) of the first substrate (15) and a second contact surface (15o') of the second substrate (15') in a Z direction,
- a first adjustment unit (4) for moving the first mount (9) at least in one X direction and/or Y direction which runs transversely to the Z direction,
- a second adjustment unit (4') for moving the second mount (9') at least in one X direction and/or Y direction,
- detection means (8, 8', 8", 8'") for:
a) detecting a first X-Y position of a first alignment marking (20) located in a peripheral region of the first substrate (15) in a first detection position which has moved in a X and/or Y direction along a first contact surface (15o),
b) detecting a second X-Y position of a second alignment marking (20) located in a peripheral region of the second substrate (15') in a second detection position which has moved in an X and/or Y direction along the second contact surface (15o'),
c) detecting a third X-Y position of a third alignment marking (20") located in a peripheral region of the first substrate (15) in the second detection position,
d) detecting a fourth X-Y position of a fourth alignment marking (20"') located in a peripheral region of the second substrate (15') in the first detection position,
- adjustment units (4, 4') for aligning the first substrate (15) relative to the second substrate (15') based on the first, second, third and fourth X-Y positions which have been detected by the detection,
- contact-making means for contact-making of the first substrate (15), which has been aligned relative to the second substrate (15'), with the second substrate (15') in the Z-direction, **characterized in that** the device comprises a controlling unit for conducting a method according to claim 1.

5. The device as claimed in Claim 4, wherein the contact-making means comprise the first and/or the second adjustment unit (4, 4').

6. The device as claimed in Claim 4 or 5, wherein the detection means have a first detection unit (11) for detection of the first and/or second alignment markings (20, 20') and a second detection unit (11') located especially on one side of the mounts (9, 9') which is opposite the first detection unit (11), for detection of the third and/or fourth alignment markings (20", 20"').

7. The device as claimed in Claim 6, wherein the first detection unit (11) has several electromagnetically operating, especially two first detection devices (8, 8') located oppositely, preferably microscopes, and/or the second detection unit (11') has several electromagnetically operating, especially two second detection devices (8", 8'") located oppositely, preferably microscopes.

8. The device as claimed in Claim 7, wherein the first detection unit (11) has a first optics fixing (6) for attaching the first detection devices (8,8') and/or the second detection unit (11') has a second optics fixing (6') for attaching the second detection devices (8", 8'"), and wherein the first detection devices (8, 8') can be moved jointly by a first fixing translation unit (5) which holds the first optics fixing (6) and/or the second detection devices (8", 8'") can be moved jointly by a second fixing translation unit (5, 5') which holds the second optics fixing (6').

9. The device as claimed in Claim 8, wherein the first detection devices (8, 8') can each be moved separately via first optics translation units (7, 7') on the first optics fixing (6) and/or the second detection devices (8", 8"') can each be moved separately via second optics translation units (7", 7"') on the second optics fixing (6').

## Revendications

1. Procédé destiné à l'alignement et à la mise en contact d'un premier substrat (15) avec un second substrat (15') présentant le déroulement suivant :
- fixation du premier substrat (15) sur une première réception (9) et du second substrat (15') sur une seconde réception (9') qui est disposée opposée à la première réception (9), dans lequel le premier et le second substrat (15, 15') sont disposés entre les première et seconde réception(s) (9, 9') avec une distance A entre une première surface de contact (15o) du premier substrat (15) et une seconde surface de contact (15o') du second substrat (15) dans un sens Z,
- déplacement de la première réception (9) vers une première unité de détection (11) dans une première position de détection et de la seconde réception (9') vers une seconde unité de détection (11') dans une deuxième position de détection opposée à 1a première position de détection,
- détection d'une première position X - Y d'un premier marquage d'alignement (20) disposé dans une partie périphérique du premier substrat (15) dans la première position de détection déplacée dans un sens X et/ou Y le long de la première surface de contact (15o),
- détection d'une deuxième position X - Y d'un deuxième marquage d'alignement (20') disposé dans une partie périphérique du second substrat (15') dans la deuxième position de détection déplacée dans un sens X et/ou Y le long de la seconde surface de contact (15o'),
- déplacement de la première réception (9) vers la seconde unité de détection (11') dans la deuxième position de détection et de la seconde réception (9') vers la première unité de détection (11) dans la première position de détection,
- détection d'une troisième position X-Y d'un troisième marquage d'alignement (20") disposé dans une partie périphérique du premier substrat (15), dans la seconde position de détection,
- détection d'une quatrième position X-Y d'un quatrième marquage d'alignement (20"') disposé dans une partie périphérique du second substrat (15'), dans la première position de détection,
- alignement du premier substrat (15) par rapport au second substrat (15') par des unités d'ajustement (4, 4') en se basant sur les première, deuxième, troisième et quatrième positions X - Y détectées par les détections et
- mise en contact du premier substrat (15) aligné opposé au second substrat (15'), avec le second substrat (15').

2. Procédé selon la revendication 1, dans lequel les premier et quatrième marquages d'alignement (20', 20) et/ou les deuxième et troisième marquages d'alignement (20", 20") sont disposés opposés dans le sens Z.

3. Procédé selon la revendication 1 ou 2, dans lequel la détection du premier et du deuxième marquage d'alignement (20', 20") et/ou la détection du troisième et du quatrième marquage d'alignement (20", 20"') s'effectue au cours d'une étape de procédé liée, en particulier simultanément, en particulier avec une première unité de détection (11) pour détecter les premier et/ou seconds marquages d'alignement (20', 20") et une seconde unité de détection (11') pour détecter les troisième et/ou quatrième marquages d'alignement (20", 20'").

4. Dispositif destiné à l'alignement et à la mise en contact d'un premier substrat (15) avec un second substrat (15') comprenant :
- une première réception (9) pour fixer le premier substrat (15) et une seconde réception (9') qui est disposée opposée à la première réception (9) pour fixer le second substrat (15'), dans lequel le premier et le second substrat (15, 15') peuvent être disposés entre les première et seconde réception(s) (9, 9') avec une distance entre une première surface de contact du premier substrat (15) et une seconde surface de contact du second substrat (15) dans un sens Z,
- une première unité d'ajustement (4) pour déplacer la première réception (9) au moins dans un sens X et/ou Y transversal au sens Z,
- une seconde unité d'ajustement (4') pour déplacer 1a seconde réception (9') au moins dans un sens X et/ou Y,
- des moyens de détection (8, 8', 8", 8"') pour
a) la détection d'une première position X - Y d'un premier marquage d'alignement (20') disposé dans une partie périphérique du premier substrat (15) dans une première position de détection déplacée dans un sens X et/ou Y le long d'une première surface de contact (15o),
b) la détection d'une deuxième position X - Y d'un deuxième marquage d'alignement (20") disposé dans une partie périphérique du second substrat (15') dans une deuxième position de détection déplacée dans un sens X et/ou Y le long d'une seconde surface de contact (15k'),
c) 1a détection d'une troisième position X-Y d'un troisième marquage d'alignement (20"') disposé dans une partie périphérique du premier substrat (15), dans 1a seconde position de détection,
d) la détection d'une quatrième position X-Y d'un quatrième marquage d'alignement (20) disposé dans une partie périphérique du second substrat (15'), dans la première position de détection,
- des unités d'ajustement (4, 4') pour aligner le premier substrat (15) par rapport au second substrat (15') en se basant sur les première, deuxième, troisième et quatrième positions X - Y détectées par les détections,
- des moyens de mise en contact pour la mise en contact du premier substrat (15) aligné opposé au second substrat (15'), avec le second substrat (15') dans le sens Z, **caractérisé en ce que** le dispositif comprend une unité de commande pour exécuter un procédé selon la revendication 1.

5. Dispositif selon la revendication 4, dans lequel les moyens de contact comprennent la première et/ou la seconde unité d'ajustement (4, 4').

6. Dispositif selon la revendication 4 ou 5, dans lequel les moyens de détection présentent une première unité de détection (11) pour détecter les premier et/ou deuxième marquages d'alignement (20, 20') et une seconde unité de détection (11') pour détecter les troisième et/ou quatrième marquages d'alignement (20", 20"'), disposée en particulier sur un côté des réceptions (9, 9') opposé à la première unité de détection (11).

7. Dispositif selon la revendication 6, dans lequel la première unité de détection (11) présente plusieurs, en particulier deux premiers appareils de détection (8, 8') opposés fonctionnant de façon électromagnétique, de préférence des microscopes, et/ou la seconde unité de détection (11') présente plusieurs, en particulier deux seconds appareils de détection (8", 8"') opposés fonctionnant de façon électromagnétique, de préférence des microscopes.

8. Dispositif selon la revendication 7, dans lequel la première unité de détection (11) présente une première fixation d'optique (6) pour appliquer les premiers appareils de détection (8, 8') et/ou la seconde unité de détection (11') présente une seconde fixation d'optique (6') pour appliquer les seconds appareils de détection (8", 8'''), et dans lequel les premiers appareils de détection (8, 8') sont mobiles conjointement par une première unité de translation de fixation (5) recevant la première optique de fixation (6) et/ou les seconds appareils de détection (8", 8"') sont mobiles conjointement par une seconde unité de translation de fixation (5, 5') recevant la seconde fixation d'optique (6').

9. Dispositif selon la revendication 8, dans lequel les premiers appareils de détection (8, 8') sont mobiles respectivement séparément par le biais de premières unités de translation d'optique (7, 7') sur la première fixation d'optique (6) et/ou les seconds appareils de détection (8", 8"') sont mobiles respectivement séparément par le biais de secondes unités de translation d'optique (7", 7"') sur la seconde fixation d'optique (6').
